# EUROPEAN PATENT APPLICATION

(11) **EP 3 691 103 A1**
(43) Date of publication of application: **05.08.2020**
(21) Application number: 19155035.9
(22) Date of filing: 01.02.2019
(51) Int. Cl.: H02M 7/00

(54) **ELECTRIC POWER MODULE**

(71) Applicant: Aptiv Technologies Limited, St. Michael (BB)
(72) Inventor: Sovva, Valerij, 40223 Düsseldorf (DE); Scheumann, Uwe, 42929 Wermelskirchen (DE); Sycha, Michael, 42285 Wuppertal (DE); Ramaekers, Udo, 58332 Schwelm (DE)
(74) Representative: Manitz Finsterwald Patent- und Rechtsanwaltspartnerschaft mbB

(57) **Abstract**

The invention relates to an electric power module, comprising a first central connection terminal for connecting to a power line, at least a second connection terminal for connecting to a power line and a plurality of first power switches electrically connected to the first central connection terminal and the second connection terminal, wherein a ring-shaped first bus-bar surrounds the first connection terminal and is integrally formed with the second connection terminal.

## Description

The present invention relates to an electric power module, comprising a first connection terminal for connecting to a power line, a second connection terminal for connecting to a power line and a plurality first power switches electrically connected to the first connection terminal and the second connection terminal.

In recent years, electric devices like electric motors working at constant speed became more and more replaced by variable speed motors being able to adjust a power output to a required load. For adjusting the speed and power output of the motor, an electric power module is interposed in the power supply of the electric motor.

Electric power modules usually are provided with a plurality of power switches which can be turned on and off to regulate the power input of the electric device. In known electric power modules, the power switches are electrically connected in parallel, whereby the current flowing from the input terminal through each of the power switches is added successively to an output current at the output terminal.

In such a geometrically serial configuration each of the power switches is located at a different distance to the output terminal. Consequently, an electric connection between the power switches and the output terminal will vary its electric resistance across its length, with the electric resistance being smallest for the electric connection between the output terminal and the power switch located closest to it. This leads to power losses through an uneven distribution of currents flowing through the power switches. Thereby, the most distant power switches exhibit the smallest current flows, whereas the power switches located closest to the output terminal will exhibit the largest current flow and consequently the largest amount of dissipated heat. This may lead to an overheating of the power switches. The dissipated heat can severely affect the lifetime of the power switches and in consequence, restrict the lifetime of the electric power module. Problems with the power and heat management can therefore determine the lifetime, but also have a large impact on the construction costs of the electric power modules.

The non prepublished international patent application PCT/EP2018/075210 shows an arrangement of power switches differing from a serial configuration. It discloses an electric connection of power switches to a power line, said connection having no bus-bars.

It is the underlying object of the present invention to provide an electric power module having an improved power and heat management.

The object is satisfied by an electric power module in accordance with claim 1, which in particular comprises a ring-shaped first bus-bar surrounding the first central connection terminal and being integrally formed with the second connection terminal.

By using a ring-shaped bus bar a larger flexibility in an arrangement of the power switches can be achieved, as the ring-shape is compatible with a multitude of arrangements of power switches.The first bus-bar is made of metal or another electrically conductive material.

In the inventive electric power module currents as well as dissipated heat are evenly distributed over the power switches. As a consequence, peaks of the current flow affecting certain power switches are omitted which reduces power losses and thus improves on the power management of the electric power module.

The inventive electric power module furthermore improves on the heat management as dissipated heat is distributed evenly over the power switches, thus avoiding the risk of an overheating of certain power switches. As the power switches can be grouped around the first central connection terminal such that electric connections between the first power switches and the first central connection terminal can be kept short, the electric connections show small electric resistances. Therefore, power losses can be minimized and the amount of dissipated heat can be reduced. The arrangement of power switches in the inventive electric power module thus not only omits localized peaks in the heat distribution, but also decreases the overall amount of dissipated heat in the electric power module.

Advantageous embodiments are set forth in the dependent claims, in the description and in the figures.

In accordance with an embodiment of the invention, the plurality of first power switches is arranged such that each of the first power switches is located at a same distance to the first central connection terminal.

In other words, the plurality of first power switches is distributed along a circle being centred on the first central connection terminal. For example, the first power switches can be distributed symmetrically along sides or corners of a triangle, a rectangle or other types of polygons, whereby the first central connection terminal is located in the respective centre of the polygon. It is also conceivable that the first power switches are distributed symmetrically across the surface of three-dimensional bodies with the first central connection terminal located in respective centres of the three-dimensional bodies.

Due to each of the first power switches having the same distance to the first central connection terminal, connections of the first power switches to the first central connection terminal have the same electric resistance. Therefore, currents as well as dissipated heat are evenly distributed over the power switches. As a consequence, peaks of the current flow affecting certain power switches are omitted, improving on the power management of the electric power module.

Although it is reasonable that the plurality of first power switches is located on one side of the circuit board only, in accordance with an embodiment of the invention, the plurality of first power switches is located on a first side and on a second side of a circuit board. The circuit board can for example be a printed circuit board (PCB). The circuit board can comprise conductive paths providing electric connections between the first power switches and the first central connection terminal. As both the first side and the second side of the circuit board are provided with first power switches, it is possible to provide an electric power module with an increased number of power switches without losing the advantages of a compact design.

The plurality of first power switches can be arranged such that adjacent first power switches on the first side and on the second side of the circuit board are located at a same distance to one another. In other words, the plurality of first power switches can be distributed symmetrically around the first central connection terminal. In this way, a distance between adjacent first power switches can be maximized which ensures an even distribution of generated heat and prevents a development of peaks in the heat distribution and overheating.

In accordance with an embodiment of the invention, the first bus-bar comprises a plurality of integrally formed contacting legs for electrically connecting the first power switches. The contacting legs could for example be formed by stamping and bending of parts of the outer periphery of the ring-shaped first bus-bar toward the circuit board.

In accordance with an embodiment of the invention, the contacting legs contact with the first and the second side of the circuit board. The first power switches can be provided at corresponding positions on the first side and on the second side of a circuit board. This simplifies an electric connection of the first power switches and the first bus-bar, as the first bus-bar can be provided with a smaller number of contacting legs which electrically connect the first bus-bar and the first power switches.

In accordance with an embodiment of the invention, the contacting legs traverse the circuit board. In other words, a single connecting leg can connect with both a first power switch located on the first side and a first power switch located on the second side of the circuit board. It is also conceivable that the contacting legs are soldered to conductive zones which are for example made by metal and form part of the circuit board. In this case the conductive zones may traverse the circuit board and connect to the first power switches on the first and second side of the circuit board.

In accordance with an embodiment of the invention, the electric power module further comprises at least one third connection terminal for connecting to a power line and a plurality of second power switches electrically connected to the first central connection terminal and the third connection terminal, wherein a second bus-bar is integrally formed with the third connection terminal. The plurality of second power switches can be located on the first side and/or on the second side of the circuit board. The plurality of second power switches can be arranged such that adjacent second power switches are located at a same distance to one another.

The second bus-bar can be of similar shape as the first bus-bar. It is also conceivable that the first and the second bus-bar have different shapes. By the provision of at least a third connection terminal, the electric power module can be connected to more than one power line and for example combine the power of two sources of electric energy. For example, the electric power module can be used to connect a first and a second electric power unit to an electric device. The first or the second power unit can be a battery, a hydrogen cell, an electric accumulator or another source of electric energy. Thereby, the first and the second power units can be of different type or can have a different voltage.

In accordance with an embodiment of the invention, the plurality of second power switches is arranged such that each of the second power switches is located at a same distance to the first central connection terminal. In other words, also the plurality of second power switches is distributed along a circle being centred on the first central connection terminal. Therefore, currents as well as dissipated heat are evenly distributed over the second power switches. Consequently, peaks of the current flow affecting certain power switches are omitted, improving on the power management of the electric power module. Advantageously, both the plurality of first power switches and the plurality of second power switches have an identical distance to the first central connection terminal. This enables a compact design and a cost-effective construction of the electric power module.

In accordance with an embodiment of the invention, the second bus-bar comprises a plurality of integrally formed contacting legs for electrically connecting to the second power switches. The contacting legs could for example be formed by a bending of the outer periphery of the second bus-bar toward the circuit board.

In accordance with an embodiment of the invention, the first and second power switches are located adjacent to one another. In other words, the plurality of first power switches and the plurality of second power switches are arranged offset to one another. This optimizes a distribution of the first and second power switches and maximizes the distances between adjacent power switches. In this way, generated heat is evenly distributed over the circuit board and heat-peaks are omitted. In accordance with an embodiment of the invention, the first and second bus bars are arranged on both sides of the circuit board and enclose the first and second power switches in a sandwich configuration. In other words, the first and second bus-bars and the circuit board are arranged in parallel planes. The power switches are distributed on the first and the second side of the circuit board while being covered by the first and second bus-bars. The bus-bars can provide an electric connection to the power lines and furthermore provide a certain degree of protection for the power switches and the circuit board.

The sandwich configuration offers the possibility of using a multitude of power switches, provided in a dense arrangement on both sides of the circuit board. Still, all the advantages of a compact design are maintained. Moreover, as manufacturing steps for both sides of electric power modules configured in this way can be similar, the production process can be simplified and the production costs can be lowered.

In accordance with an embodiment of the invention, the first bus-bar and the second bus-bar form a lug for connecting to the second and third connection terminals, respectively. This allows a fast, simple and secure connection of the second and third connection terminals to the power lines. The lug can form a flat and/or elongated peripheral extension of the first and second bus-bars. The second and third connection terminals can for example be provided in form of through holes in the lugs or in the bus-bars. The electric connection can for example be established by a screw terminal inserted into the connection terminal and connected to the power line via a connector, or via a cable. Other possibilities include for example a connection via a cable which is press-fitted into the second and third connection terminals.

To electrically separate and not confuse the cables which connect the power lines to the second and third connection terminals, the lugs and corresponding connection terminals can be arranged such that in projection they do not overlap, but enclose an angle. For example, the lugs of the first and second bus-bars can enclose an angle of 90, 180 or 270 degrees.

In accordance with an embodiment of the invention, the first central connection terminal traverses both the first and second bus-bar. Therefore, the first central connection terminal can be connected to a power line from both sides of the circuit board.

In accordance with an embodiment of the invention, the first central connection terminal comprises a cylindrical stud. The stud is made of metal or another electrically conductive material and ensures a robust and save electric connection. Other embodiments can have first central connection terminals of different type for connecting to an electric power line.

In accordance with an embodiment of the invention, the electric power module further comprises a control port for connecting to a control unit, wherein the control port is electrically connected to the plurality of first and second power switches for controlling the power switches. For example, the control port can be a plug which can be connected to a control unit for controlling the power switches and hence an output current flowing for example through the first central connection terminal to power an electric device. The control unit can comprise a logic which controls the state of the first and/or second power switches to adjust the output current to a required load of the electric device. The first and/or second power switches can be transistors or MOSFETs which can be controlled by analogue or digital means. Such power switches are cost-effective to produce. Moreover, they can be of small size and can easily be integrated in the electric power module.

The electric power modules can be packetized and grouped together to provide fully scalable solutions for some applications. For example, a plurality of electric power modules can be connected in series to combine several sources of electric energy, whereby the sources of electric energy can be of different type. When combining several electric power modules it is also conceivable that the electric power modules are grouped on top of each other in a sandwich configuration. Such configuration can advantageously be provided with a single cylindrical stud acting as first central connection terminal of all combined electric power modules.

The invention will be described in the following with reference to an embodiment and to the drawings. There are shown in:
Fig. 1 a top view of an embodiment of an electric power module;
Fig. 2 a side view of the embodiment of Fig. 1 with screw terminals connected to the second and third connection terminals;
Fig. 3 a sectional view of the embodiment of Fig. 1 along line B-B of Fig. 2;
Fig. 4 a perspective view of the embodiment of Fig. 1; and
Fig. 5 a sample application of the embodiment of Fig. 1.

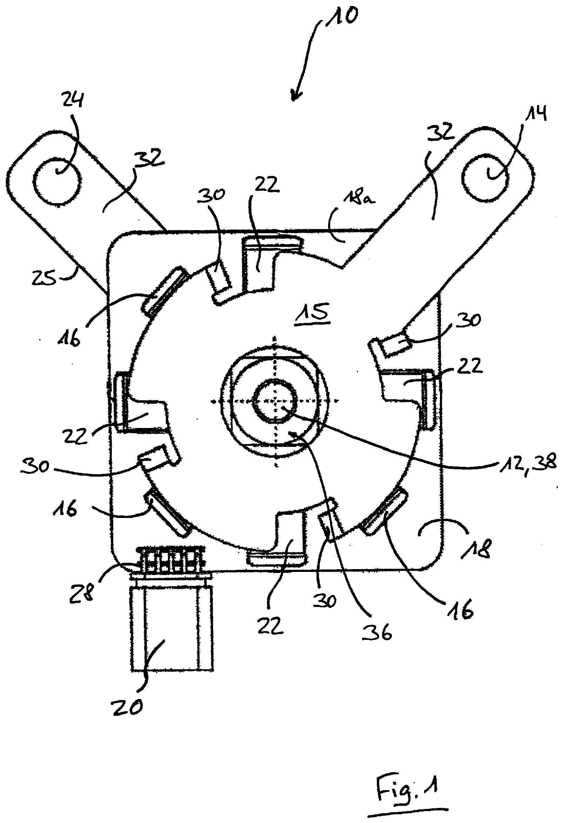

Fig. 1 shows a top view of an embodiment of an electric power module 10. The electric power module 10 comprises a first central connection terminal 12, a second connection terminal 14, a third connection terminal 24 and a plurality of first power switches 16 arranged on a circuit board 18. The first, second and third connection terminals 12, 14, 24 can be connected to electric power lines to connect with a battery, a hydrogen cell, an electric accumulator or another source of electric energy, or with an electric load. The circuit board 18 comprises a first side 18a which is shown in the top view of Fig. 1 and a second side 18b opposite to the first side 18a. Although in the shown embodiment having a quadratic shape, the circuit board 18 is not limited to this shape. In other embodiments, the circuit board 18 can for example be rectangular or round or can have another shape.

The first central connection terminal 12 is surrounded by a ring-shaped first bus-bar 15 which is integrally formed with the second connection terminal 14. The first central connection terminal 12 is further surrounded by a second bus-bar 25 being integrally formed with the third connection terminal 24. The second bus-bar 25 of this embodiment is ring-shaped. Other embodiments, however, could be provided with second bus-bars 25 being of different shape. Both the first and second bus-bar 15, 25 are made of metal or another electrically conductive material.

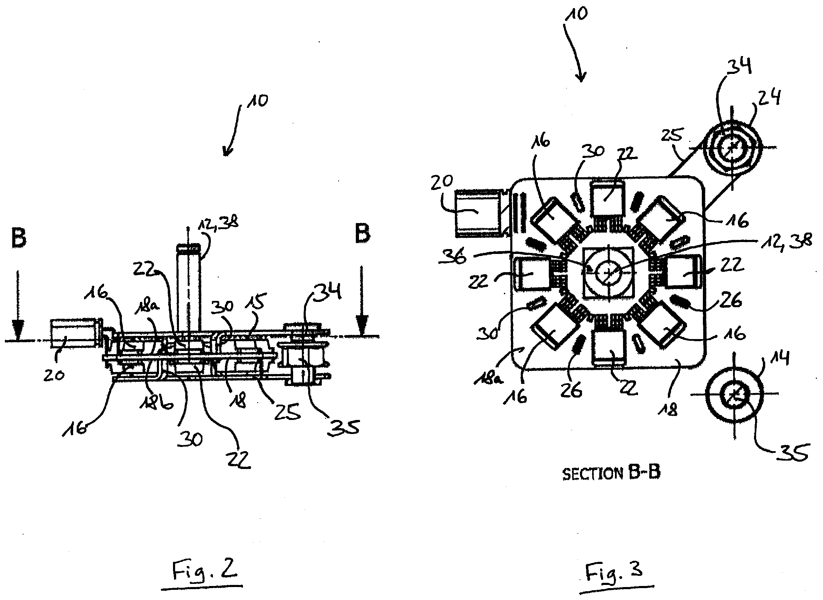

The plurality of first power switches 16 is arranged on the first side 18a and on the second side 18b of the circuit board 18 and electrically connected to the second connection terminal 14 and to the first central connection terminal 12. The electric power module 10 further comprises a plurality of second power switches 22 (see Fig. 2) and a control port or plug 20 which in the shown embodiment is located at a peripheral region of the first side 18a of the circuit board 18. The second power switches 22 are arranged on the first side 18a and on the second side 18b of the circuit board 18 and are electrically connected to a third connection terminal 24 and the first central connection terminal 12.

The first and second power switches 16, 22 are arranged adjacent to one another on the first side 18a and the second side 18b of the circuit board. Thereby, the plurality of first power switches 16 is arranged such that adjacent first power switches 16 on the first side 18a and on the second side 18b of the circuit board 18 are located at a same distance to one another. Similarly, the plurality of second power switches 22 is arranged such that adjacent second power switches 22 on the first side 18a and on the second side 18b of the circuit board 18 are located at a same distance to one another. Thereby, the first and second power switches 16, 22 are provided at corresponding positions on the first side 18a and on the second side 18b of the circuit board 18, respectively.

Fig. 2 presents a side view of the embodiment of Fig. 1. As shown in Fig. 2, the first and second bus-bars 15 and 25 are arranged above and below the circuit board 18, enclosing the first and second power switches 16, 22 in a sandwich configuration. In other words, the second and third connection terminals 14, 24 and the ring-shaped first and second bus-bars 15, 25 are arranged parallel to the circuit board 18 and are in electric contact with respective sides 18a, 18b of the circuit board. In order to electrically connect to the first and second power switches 16, 22, the first bus-bar 15 and the second bus-bar 25 comprise a plurality of integrally formed contacting legs 30. The contacting legs 30 are formed by stamping and bending of a part of the outer periphery of the first and second bus-bars 15, 25 toward the circuit board 18.

The contacting legs 30 are electrically connected to conductive zones 26 (see Fig. 3) on the circuit board 18. The conductive zones 26 comprise a conductive material and traverse the circuit board 18 adjacent to the first and second power switches 16, 22. Each of the conductive zones 26 electrically connects to a pair of first or second power switches 16, 22 provided at corresponding positions on both sides 18a, 18b of the circuit board 18. Therefore, each of the contacting legs 30 electrically connects to two power switches located on opposite sides 18a, 18b of the circuit board 18 in parallel.

The first central connection terminal 12 comprises a cylindrical stud 38. The stud 38 is made of metal or another electrically conductive material and ensures a robust and save electric connection of the electric power module 10 and a power line. The cylindrical stud 38 is electrically conducting screwed to the circuit board 18.

Fig. 3 presents a sectional view of the embodiment of Fig. 2 across the line B-B. Each of the first and second power switches 16, 22 is electrically connected to the respective second and third connection terminals 14 and 24 by a conductive path. Conductive paths (all not shown) also connect each of the first and second power switches 16, 22 to the first central connection terminal 12. Moreover, conductive paths connect the control port 20 with each of the first and second power switches 16, 22.

For an easy and save electric connection to power lines, the first bus-bar 15 and the second bus-bar 25 form a lug 32 for connecting to the second and third connection terminals 14, 24, respectively.The lug 32 forms a flat and/or elongated peripheral extension of the first and second bus-bar 15, 25. At an outer end, the lug 32 is provided with the second and third connection terminal 14, 24, respectively. For a fast and secure electric connection screw terminals 34 and 35 (see Fig. 2) connectable to power lines via cables are inserted into the second and third connection terminals 14 and 24, respectively. Other connecting options include for example a press-fit of a cable into the second or third connection terminal 14, 24. To electrically separate and not confuse the cables which connect the electric power module 10 to different power lines, the lugs 32 of the first and third connection terminal 14, 24 are arranged such that they include an angle of 90 degrees.

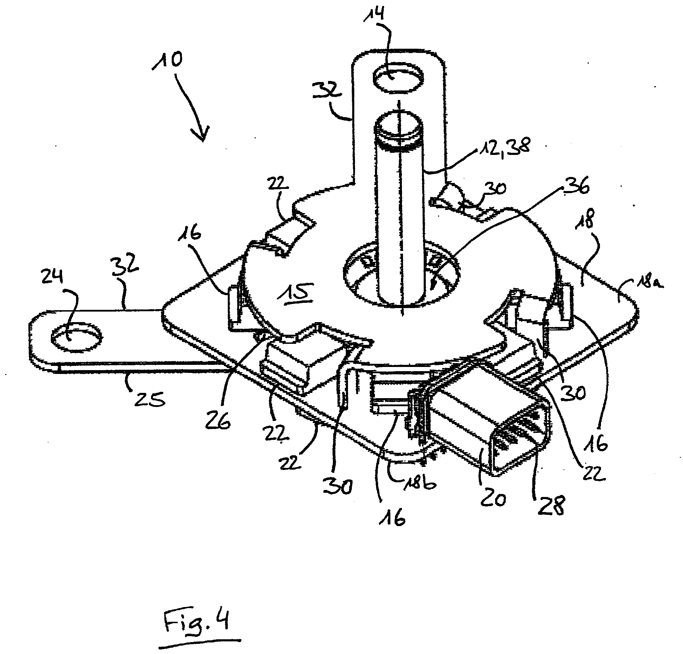

Fig. 4 presents a perspective view of the embodiment of Fig. 1. The first power switches 16 and the second power switches 22 are transistors. The transistors 16, 22 comprise a gate terminal, a source terminal and a drain terminal (all not shown). Conductive paths on the circuit board 18 can for example electrically connect the gate terminal to the control port 20, the source terminal to the respective second and third connection terminals 14, 24 and the drain terminal to the first central connection terminal 12. Depending on the state of the gate terminal, each transistor can either be in an on-state with current flowing through the drain terminal or in an off-state, whereby a current flow through the drain terminal is blocked.

For controlling each of the transistors separately, the control port 20 is provided with a plurality of pins 28, wherein a conductive path electrically connects each of the pins 28 to a gate terminal of one of the transistors 16, 22.

The control port 20 can be connected to a control unit (not shown) for controlling the power switches 16, 22 and hence the power output of the electric power module. The control unit can comprise a logic which controls the state of the first and/or second power switches 16, 22 to adjust the output current.

The electric power module 10 offers various modes of operation. In a first mode of operation the electric power module 10 can act as an integrator of electric power. In this case the second and third connection terminals 14, 24 are used as input terminals by connecting them both to sources of electric energy. A combined power of both sources is then output via the first central connection terminal 12 and can for example be used to drive an electric device. In a second mode of operation the electric power module 10 can act as a distributor of electric power. Thereby, the electric power module 10 is operated in a reversed connection configuration with the first central connection terminal 12 acting as input terminal of electric power. The electric power module 10 then distributes the electric power in a controlled way to the second and third connection terminals 14, 24 which now act as output terminals.

In the first operation mode as an integrator of electric power, currents from two sources of electric energy flow through the first and second power switches 16, 22 and are merged in a merging region 36 surrounding the first central connection terminal 12 (see Fig. 1). Due to the symmetric arrangement on the circuit board 18, the first and second power switches 16, 22 are located at a same distance to the merging region 36 at which all currents flowing through the power switches 16, 22 have merged. In other words, the first and second power switches 16, 22 are distributed along circles of similar radii which are each centred on the merging region 36.

Due to each of the first and second power switches 16, 22 having the same distance to the merging region 36, conductive paths of the power switches 16, 22 to the merging region 36 have the same electric resistance. As a consequence, peaks of the current flow affecting certain of the power switches 16, 22 are omitted, reducing power losses and thus improving the power management of the electric power module. At the same time also the heat management is improved, as due to the reduced power losses the overall amount of heat dissipated in the electric power module 10 is reduced. Moreover, dissipated heat is distributed evenly over the power switches 16, 22, avoiding the risk of an overheating of the power switches 16, 22.

Due to the improved power and heat management, the lifetime of the electric power module 10 is increased.

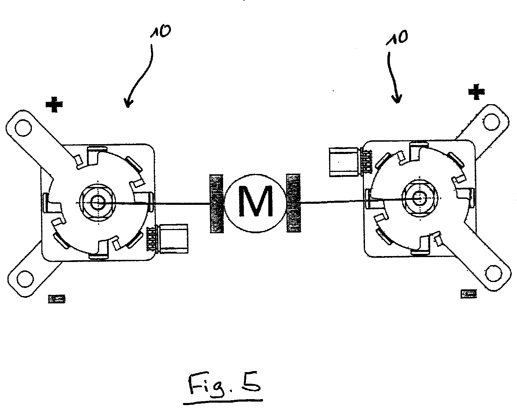

In Fig. 5, a sample application of the inventive electric power module 10 is presented, whereby electric power modules 10 are used as driver of a bi-directional electric motor M. In this example two electric power modules 10 operated in integrator mode are electrically connected to a bi-directional electric motor M, whereby the two electric power modules 10 are supplied by electric power of inverted polarity.

### Reference numeral list

- 10: electric power module
- 12: first central connection terminal
- 14: second connection terminal
- 15: first bus-bar
- 16: first power switch
- 18: circuit board
- 18a: first side of the circuit board
- 18b: second side of the circuit board
- 20: control port
- 22: second power switch
- 24: third connection terminal
- 25: second bus-bar
- 26: conductive zone
- 28: pin
- 30: contacting leg
- 32: lug
- 34: screw terminal
- 35: screw terminal
- 36: merging region
- 38: stud
- M: bi-directional electric motor

## Claims

1. An electric power module (10), comprising a first central connection terminal (12) for connecting to a power line, at least a second connection terminal (14) for connecting to a power line and a plurality of first power switches (16) electrically connected to the first central connection terminal (12) and the second connection terminal (14), wherein a ring-shaped first bus-bar (15) surrounds the first connection terminal (12) and is integrally formed with the second connection terminal (14).

2. The electric power module (10) in accordance with claim 1, wherein the plurality of first power switches (16) is arranged such that each of the first power switches (16) is located at a same distance to the first central connection terminal (12).

3. The electric power module (10) in accordance with claim 1 or 2, wherein the plurality of first power switches (16) is located on a first side (18a) and on a second side (18b) of a circuit board (18).

4. The electric power module (10) in accordance with any of claims 1 to 3, wherein the first bus-bar (15) comprises a plurality of integrally formed contacting legs (30) for electrically connecting the first power switches (16).

5. The electric power module (10) in accordance with claims 3 and 4, wherein the contacting legs (30) contact with the first and the second side (18a, 18b) of the circuit board (18).

6. The electric power module (10) in accordance with claim 5, wherein the contacting legs (30) traverse the circuit board (18).

7. The electric power module (10) in accordance with any of the preceding claims, further comprising at least one third connection terminal (24) for connecting to a power line and a plurality of second power switches (22) electrically connected to the first central connection terminal (12) and the third connection terminal (24), wherein a second bus-bar (25) is integrally formed with the third connection terminal (24).

8. The electric power module (10) in accordance with claim 7, wherein the plurality of second power switches (22) is arranged such that each of the second power switches (22) is located at a same distance to the first central connection terminal (12).

9. The electric power module (10) in accordance with claim 7 or 8, wherein the second bus-bar (25) comprises a plurality of integrally formed contacting legs (30) for electrically connecting to the second power switches (22).

10. The electric power module (10) in accordance with any of claims 7 to 9, wherein the first and second power switches (16, 22) are located adjacent to one another.

11. The electric power module (10) in accordance with claims 3 and 7, wherein the first and second bus bars (15, 25) are arranged on both sides (18a, 18b) of the circuit board (18) and enclose the first and second power switches (16, 22) in a sandwich configuration.

12. The electric power module (10) in accordance with claims 1 and 7, wherein the first bus-bar (15) and the second bus-bar form a lug (32) for connecting to the second and third connection terminals (14, 24), respectively.

13. The electric power module (10) in accordance with claims 1 and 7, wherein the first central connection terminal (12) traverses both the first and second bus-bar (15, 25).

14. The electric power module (10) in accordance with any of the preceding claims, wherein the first central connection terminal (12) comprises a cylindrical stud (38).

15. The electric power module in accordance with any of the preceding claims, further comprising a control port (20) for connecting to a control unit, wherein the control port (20) is electrically connected to the plurality of power switches (16, 22) for controlling the power switches (16, 22).
